Europäisches Patentamt

(19) European Patent Office

Office européen des brevets

(11) Numéro de publication: **0168287 B1**

(12) **FASCICULE DE BREVET EUROPEEN**

(51) Int. Cl.⁴: **H 05 K 3/24, H 05 K 3/40, H 05 K 3/36**

(45) Date de publication du fascicule du brevet: **16.08.89**

(21) Numéro de dépôt: **85401108.7**

(22) Date de dépôt: **05.06.85**

(54) Procédé pour la réalisation d'un circuit imprimé et circuit imprimé obtenu par la mise en oeuvre dudit procédé.

(30) Priorité: **08.06.84  FR 8409054**

(43) Date de publication de la demande:
**15.01.86 Bulletin 86/3**

(45) Mention de la délivrance du brevet:
**16.08.89 Bulletin 89/33**

(84) Etats contractants désignés:
**DE GB IT**

(56) Documents cités:
**EP-A- 0 028 657**
**WO-A-79/00083**
**DE-A- 1 805 396**
**FR-A- 2 130 100**
**US-A- 3 470 043**

**SOLID STATE TECHNOLOGY, vol. 16, no. 7, juillet 1973, pages 36-40, Applied Physics Laboratory, Washington, US; R.E. HICKS: "Thin-film electroplated funnel thru-holes on polyimide resin and laminated boards"**
**IBM TECHNICAL DISCLOSURE BULLETIN, vol. 1, no. 5, fevrier 1959, page 36, New York, US; R.O. HUOPANA: "Printed wiring board manufacturing"**
**ELECTRONICS AND COMMUNICATIONS IN JAPAN, vol. 59-C, no. 7, 1976, pages 97-106, Washington, US; Y. KANEKO et al.: "One method of high-density assembly for LSI chips"**

(73) Titulaire: **AEROSPATIALE Société Nationale Industrielle, 37, Boulevard de Montmorency, F-75781 Paris Cédex 16 (FR)**

(72) Inventeur: **Barre, Albert, 18 Clos de la Pierre Plate, F-78120 Vieille Eglise en Yvelines (FR)**

(74) Mandataire: **Bonnetat, Christian et al, Cabinet PROPI Conseils 23 rue de Léningrad, F-75008 Paris (FR)**

## Description

La présente invention concerne un procédé pour la réalisation d'un circuit imprimé constitué d'un substrat de matière électriquement isolante portant, sur au moins l'une de ses faces, des éléments métalliques électriquement conducteurs, tels que conducteurs de liaison, plages de contact, parois conductrices pour des trous traversant ledit substrat, ou analogues. Un procédé selon le préambule de la revendication 1 est connu du document FR-A 2 130 100.

On sait que les plages de contact d'un tel circuit imprimé peuvent servir à la connexion de celui-ci à des dispositifs électriques, par exemple d'autres circuits imprimés, grâce à la coopération, à la manière des contacts de connecteurs, desdites plages de contact avec des plages de contact correspondantes portées par lesdits dispositifs électriques. On sait de plus que, afin d'obtenir un contact électrique aussi bon que possible entre lesdites plages de contact respectivement coopérantes, il est avantageux de revêtir celles-ci d'au moins une couche d'un métal non oxydable tel que l'or, avec éventuellement interposition d'une couche de nickel ou d'un autre métal.

De façon connue, un tel revêtement d'or est effectué par électrodéposition après photogravure desdits éléments métalliques du circuit imprimé, ce qui nécessite de réaliser une liaison électrique entre ceux desdits éléments métalliques qui doivent recevoir ledit revêtement.

Il est connu de réaliser des pistes imprimées revêtues de couches or sur nickel ou autres sur des circuit imprimés pour former le connecteur mâle qui est inséré dans le connecteur femelle de manière à assurer l'interconnexion électrique. Ces pistes imprimées arrivent perpendiculairement au bord de l'une des faces du circuit imprimé selon un peigne. Elles sont réalisées selon des procédés de fabrication connus. Le revêtement de type or sur nickel doit être fait après gravure. Cette opération de revêtement exige impérativement la mise en commun (liaison électrique) des pistes à l'extérieur du contour du circuit.

La réalisation des zones de contact revêtues de couches or sur nickel ou autres à n'importe quel endroit du circuit par des procédés de fabrication connus, exige de mettre en commun tous les contacts du circuit par l'intermédiaire de conducteurs auxiliaires extérieurs au circuit ou un dispositif spécifique complexe tant du point de vue réalisation que du point de vue emploi.

Il en résulte une mise en œuvre complexe pour réaliser des plages de contacts à tout emplacement désiré du substrat isolant, qui ne se trouverait pas à la périphérie de celle-ci telle que décrite, par exemple, dans le brevet américain 4 125 310.

La présente invention a pour objet de remédier à ces inconvénients. Elle concerne un procédé de réalisation de circuits imprimés permettant de réaliser par électrodéposition des contacts à tout emplacement désiré, même non reliés à la périphérie et de simplifier les opérations de revêtements protecteurs sur les zones désignées.

Plus précisément, le procédé selon l'invention, permet de réaliser des contacts en protubérance et des zones de contact sur un circuit imprimé, qu'il soit de type:

- simple face, double face ou multicouche souple,
- simple face, double face ou multicouche rigide,
- multicouche comportant à la fois des parties souples et des parties rigides. Ce résultat est obtenu en procédant à la gravure après réalisation des contacts en protubérance et des revêtements protecteurs, couches or sur nickel.

A cette fin, selon l'invention, le procédé pour la réalisation d'un circuit imprimé constitué d'un substrat de matière électriquement isolante portant, sur au moins l'une de ses faces, des éléments métalliques dont au moins certains d'entre eux doivent subir un traitement nécessitant qu'ils soient électriquement reliés ensemble selon le préambule de la revendication 1, est remarquable en ce que l'on commence par déposer sur ladite couche métallique conductrice des zones métalliques qui sont en correspondance aussi bien avec les éléments métalliques qui ne doivent pas être recouverts du revêtement métallique qu'avec ceux qui doivent l'être; et
- en ce que, après réalisation dudit revêtement en un métal non oxydable sur les éléments correspondants, on recouvre lesdites zones métalliques d'un film photosensible exposé et développé et on procède à ladite élimination desdites parties extérieures de ladite couche métallique.

Un métal non oxydable peut être choisi parmi l'or, le nickel ou le palladium ou autre.

La présente invention concerne également les circuits imprimés obtenus selon l'invention. Un tel circuit imprimé est avantageusement tel que ses contacts sont disposés de manière à pouvoir être appliqués sur les contacts d'un autre circuit; le contact électrique entre les deux circuits étant assuré par pression et coopération des contacts respectifs.

De façon avantageuse, ladite couche métallique conductrice portée par ledit substrat isolant et lesdites zones métalliques déposées sont en une matière choisie parmi le cuivre, l'aluminium, le zinc, le cadmium ou un alliage de ceux-ci.

Les figures de dessin annexé feront bien comprendre comment l'invention peut être réalisée. Sur ces figures, des références identiques désignent des éléments semblables.

Les figures 1 à 11 illustrent différentes étapes d'un mode de mise en œuvre du procédé selon l'invention.

La figure 12 est une vue en plan d'un exemple de réalisation d'un circuit imprimé selon l'invention, la partie de gauche dudit circuit imprimé étant supposée revêtue d'un film opaque, électriquement isolant, non représenté sur la partie droite dudit circuit imprimé.

La figure 13 est une vue en plan d'un autre exemple de réalisation d'un circuit imprimé selon l'invention, la partie gauche dudit circuit imprimé étant supposée revêtue d'un film opaque, électriquement isolant, non représenté sur la partie droite dudit circuit imprimé.

La figure 14 représente en coupe partielle deux circuits imprimés selon l'invention positionnés en contact.

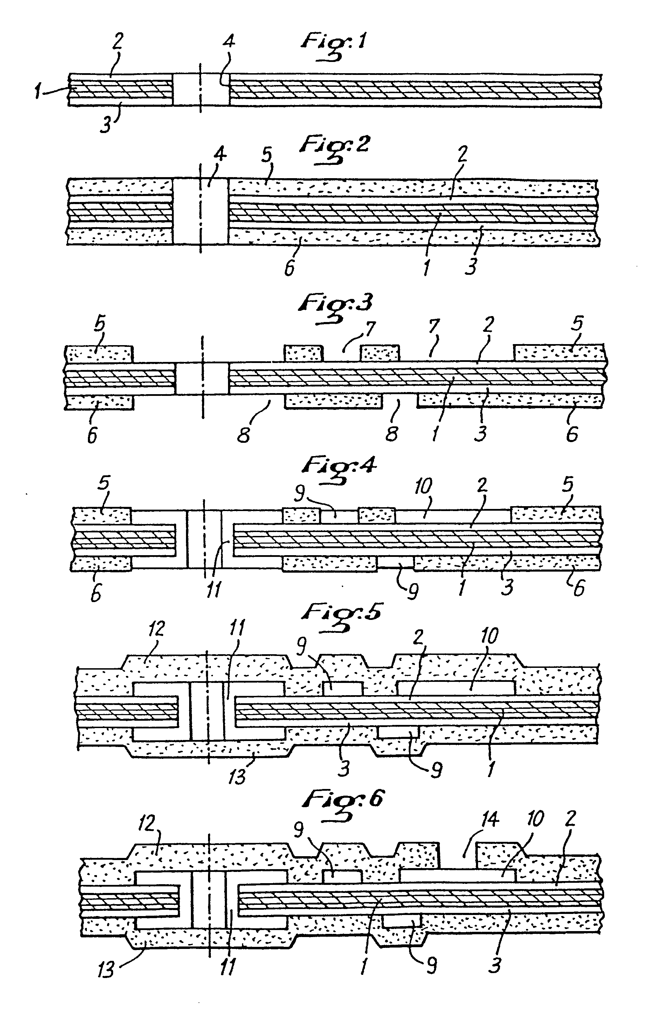

Le mode de mise en œuvre du procédé selon l'invention, illustré par les figures 1 à 11, utilise un substrat 1 de matière électriquement isolante, revêtue uniformément sur ses deux faces d'une couche métallique 2 ou 3 (voir la figure 1). Par exemple, les couches métalliques 2 et 3 sont en cuivre laminé, de 18 à 70 microns d'épaisseur, et sont collées, à l'aide d'une résine adhésive époxyde ou acrylique, sur ledit substrat 1, qui peut être réalisée en un polyimide. Le support 1, 2, 3 peut être percé de trous traversants 4, destinés à être métallisés.

Comme le montre la figure 2, le support 1, 2, 3 est recouvert sur ses deux faces de films photosensibles 5 et 6, respectivement, qui sont exposés, puis développés et partiellement éliminés pour délimiter des ouvertures 7 ou 8 (voir la figure 3). Par métallisation par exemple, on peut déposer dans les ouvertures 7 du film 5 et dans les ouvertures 8 du film 6, une couche de cuivre de l'ordre de 35 microns d'épaisseur pour former des zones 9 (correspondant, entre autres, aux conducteurs à obtenir), des zones 10 (correspondant, entre autres, aux contacts à obtenir) et des zones 11 (correspondant, entre autres, aux parois métallisées des trous 4 et à des pastilles solidaires desdites parois métallisées). Cette étape du procédé selon l'invention est représentée sur la figure 4. Ensuite, les restes des films photosensibles 5 et 6 sont éliminés et de nouveaux films photosensibles 12 et 13 sont disposés sur le support 1, 2, 3 et les zones 9, 10 et 11 qu'il porte (voir la figure 5).

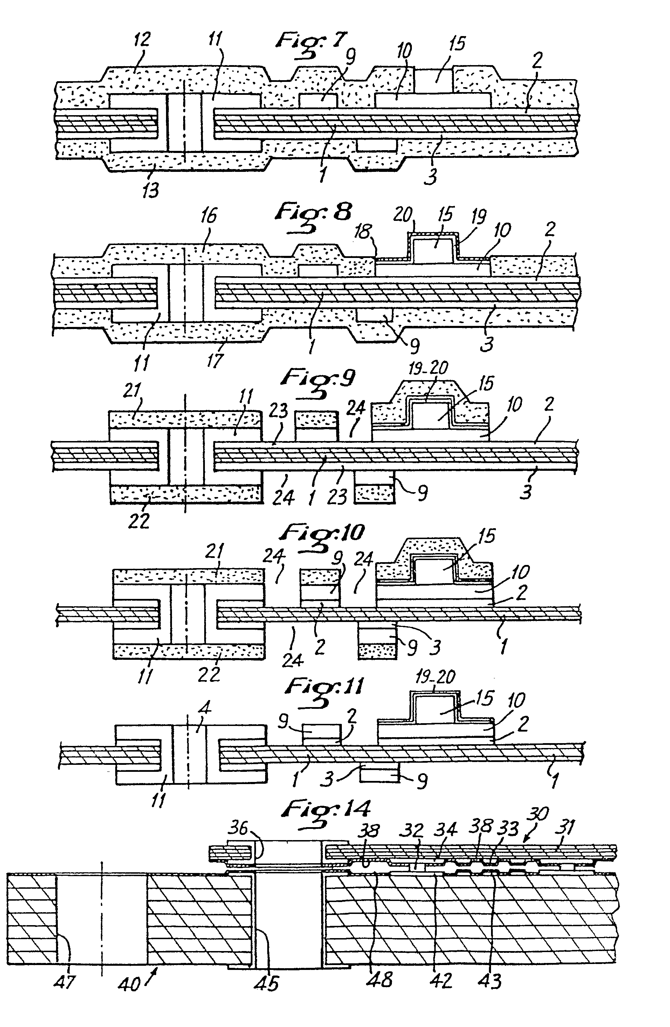

Les nouveaux films 12 et 13 sont exposés, développés et partiellement éliminés pour ménager des ouvertures 14 à l'aplomb des zones 10 (voir la figure 6). Dans les ouvertures 14 on peut déposer, par métallisation, une couche de cuivre de l'ordre de 70 microns d'épaisseur, pour former des zones 15, destinées à former, avec les zones 10 sous-jacentes, des contacts protubérants (voir la figure 7). Ensuite, les restes des films 12 et 13 sont éliminés.

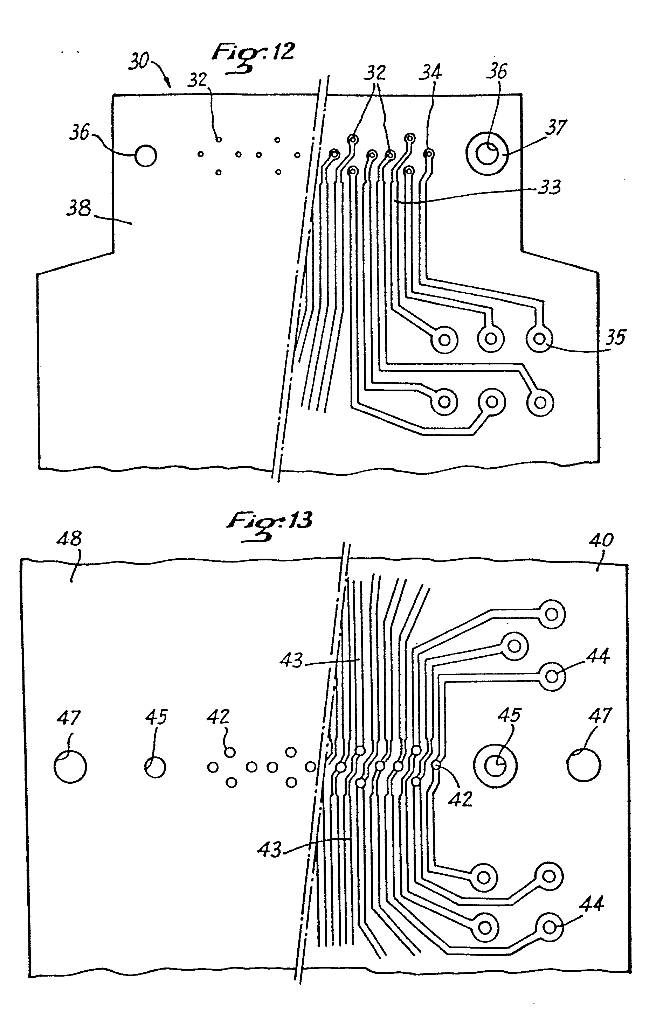

De nouveaux films photosensibles 16 et 17 sont disposés sur le support 1, 2, 3 et les zones 9, 10, 11 et 15 qu'il porte. Ces films 16 et 17 sont exposés, développés et partiellement éliminés pour délimiter des ouvertures 18 à l'aplomb des zones 10 et 15. Grâce aux ouvertures 18, on peut revêtir tous les ensembles de zones 10–15, électriquement reliés les uns aux autres par les couches métalliques 2 ou 3, d'une première couche de nickel 19 (par exemple de 5 à 10 microns d'épaisseur), puis d'une seconde couche d'or 20 (par exemple de 1 à 2 microns d'épaisseur) par la mise en œuvre usuelle d'un processus d'électro-déposition (voir la figure 8).

Ensuite, les restes des films photosensibles 16 et 17 sont éliminés.

Le support 1, 2, 3, les zones 9, 10, 11 et 15 et les couches 19 et 20 sont recouvertes de nouveaux films photosensibles 21 et 22, qui sont exposés, développés, puis partiellement éliminés pour ne laisser subsister que les parties de ceux-ci qui recouvrent lesdites zones et couches 9, 10, 11, 15, 19 et 20. Par suite, les portions 23 des couches métalliques 2 et 3 se trouvant entre lesdites zones 9, 10 et 11 sont mises à nu (voir la figure 9) en regard d'ouvertures 24. A travers lesdites ouvertures 24 des films 21 et 22, on réalise l'élimination des portions 23 des couches métalliques 2 et 3 (voir la figure 10).

On élimine ensuite les restes des films 21 et 22 et on obtient le circuit imprimé définitif de la figure 11, dans lequel:

– les conducteurs sont formés par la superposition des zones 9 et des portions de couches métalliques 2 et 3 sous-jacentes;
– les contacts protubérants sont formés par la superposition des zones 15, des zones 10 et des portions de couches métalliques 2 et 3 sous-jacentes aux zones 10;
– les métallisations des trous 4 sont formées par les zones 11 et les parties sous-jacentes des couches 2 et 3.

Ainsi, selon l'invention, le circuit imprimé est fabriqué sur les couches métalliques conductrices 2 et 3, qui sont utilisées pour des dépôts successifs, puis éliminées partiellement par la suite de façon à obtenir ledit circuit imprimé.

A l'aide de la description ci-dessus, on conçoit aisément que:
– le substrat électriquement isolant 1 peut être choisi souple ou rigide et,
– le circuit imprimé réalisé peut être à simple face, à double face ou encore à multicouche.

Par ailleurs, quoique à l'aide des figures 1 à 11, on ait illustré la réalisation de contacts 2, 10, 15, 19, 20 protubérants, il va de soi que l'on peut de la même manière réaliser à l'aide de l'invention des contacts non protubérants (c'est-à-dire ne comportant pas la partie saillante 15) revêtus des couches 19 et 20.

Sur la figure 12, on a représenté une vue en plan partielle d'un circuit imprimé 30 du type de celui montré par la figure 11. Le substrat isolant 31 de ce circuit imprimé (voir la figure 14) est mince et souple. Ce circuit imprimé 30 comporte des contacts protubérants 32 semblables aux contacts 2, 10, 15, 19, 20 du circuit imprimé de la figure 11, ainsi que des conducteurs imprimés 33, analogues aux conducteurs 2, 9 ou 3, 9 ci-dessus, chargés d'assurer diverses interconnexions électriques et terminés à une extrémité par des pastilles 34 (analogues aux zones 10) faisant partie desdits contacts protubérants 32. Les pastilles 34 et donc les contacts protubérants 32, sont disposés selon des motifs quadrangulaires alignés.

A leur extrémité, les conducteurs imprimés 33 peuvent se terminer par des trous métallisés 35 (analogues aux trous métallisés 4, 11).

Le circuit imprimé souple 30 peut être pourvu d'autres trous métallisés 36 à pastilles 37 (également du type de trous 4, 11) susceptibles de servir au positionnement dudit circuit imprimé 30. Un film isolant opaque 38 (seulement figuré sur la partie gauche de la figure 12) recouvre le circuit imprimé 30 pour ne laisser apparaître que les parties protubérantes 15, 19, 20 des contacts 32 et les trous métallisés 36.

La figure 13 montre un autre mode de réalisation 40 du circuit imprimé selon l'invention, susceptible de coopérer avec le circuit imprimé 30 (voir la figure 14). Le substrat isolant 41 du circuit imprimé 40 est rigide et par exemple réalisé en un stratifié verre époxy ou polyimide. Ce circuit imprimé 40 comprend des pastilles 42 formant les zones de contact disposées selon une disposition calquée sur celle des contacts protubérants 32 portés par le circuit imprimé 30. Les contacts 42 sont identiques aux contacts de type 2, 10, 15, 19, 20 mais ne comportent pas la partie protubérante 15, c'est-à-dire que les couches 19 et 20 sont déposées directement sur la zone 10. Les pastilles 42 sont reliées à des conducteurs imprimés 43 assurant l'interconnexion électrique avec des trous métallisés 44 qui permettent la fixation et la connexion de composants électroniques fonctionnels. Le circuit imprimé 40 comporte des trous métallisés polyvalents 45 et 46 susceptibles d'assurer le positionnement des pastilles 42 par rapport aux contacts protubérants 32 portés par le circuit imprimé 30 et des trous 47 qui permettent la fixation d'un dispositif de pression et de blocage des circuits imprimés 30 et 40 entre eux et d'immobiliser les contacts. Un film isolant 48 recouvre le circuit imprimé 40 pour ne laisser apparaître que les pastilles 42 formant les zones de contact et les trous 45 et 47 et assurant l'isolement des conducteurs imprimés 48 entre eux.

La figure 14 représente en coupe partielle les circuits imprimés 30 et 40 positionnés en simple contact, les contacts protubérants 32 étant pressés contre les pastilles 42 par un dispositif approprié.

## Revendications

1. Procédé pour la réalisation d'un circuit imprimé constitué d'un substrat (1) de matière électriquement isolante portant, sur au moins une de ses faces, des éléments métalliques dont certains doivent être recouverts d'un revêtement métallique, procédé selon lequel:
- ledit substrat de matière électriquement isolante (1) est préalablement revêtu d'une couche métallique conductrice (2 ou 3) sur ladite face devant porter lesdits éléments métalliques;
- lesdits éléments métalliques (10, 15), qui correspondent à ceux desdits éléments devant être recouverts dudit revêtement métallique et qui sont électriquement reliés entre eux par ladite couche métallique (2 ou 3), sont soumis à un traitement d'électro-déposition; et
- l'on procède ensuite à l'élimination des parties (23) de ladite couche métallique (2 ou 3) extérieures auxdits éléments caractérisé
- en ce que l'on commence par déposer sur ladite couche métallique conductrice (2 ou 3) des zones métalliques (9, 10, 11 et 15) qui sont en correspondance aussi bien avec les éléments métalliques qui ne doivent pas être recouverts de revêtement métallique qu'avec ceux qui doivent l'être; et
- en ce que, après réalisation dudit revêtement (19, 20) en un métal non oxydable sur les éléments (10, 15) correspondants, on recouvre lesdites zones métalliques d'un film photosensible exposé et développé (21, 22) et on procède à ladite élimination desdites parties extérieures (23) de ladite couche métallique (2, 3).

2. Circuit imprimé obtenu par la mise en œuvre du procédé selon la revendication 1, constitué d'un substrat (1) de matière électriquement isolante portant, sur au moins une de ses faces, des éléments métalliques dont certains sont recouverts d'un revêtement métallique, une couche métallique (2, 3) étant disposée entre ledit substrat et lesdits éléments métalliques, caractérisé en ce que lesdits éléments métalliques (10, 15) revêtus d'une couche de métal non oxydable forment des contacts, pour la liaison électrique dudit circuit imprimé à d'autres dispositifs électriques.

3. Circuit imprimé selon la revendication 2, caractérisé en ce que lesdits contacts sont protubérants.

4. Circuit imprimé selon l'une des revendications 2 ou 3, caractérisé en ce que ses contacts sont disposés de manière à pouvoir être appliqués sur les contacts d'un autre circuit imprimé tel que spécifié sous les revendications 2 ou 3, la connexion électrique entre ces deux circuits imprimés étant assurée par la coopération des contacts de chacun d'entre eux avec les contacts de l'autre.

## Patentansprüche

1. Verfahren zur Herstellung einer gedruckten Schaltung bestehend aus einem Substrat (1) aus einem elektrisch isolierenden Werkstoff, das auf zumindest einer seiner Flächen Metallelemente trägt, von denen bestimmte mit einem Metallüberzug versehen sein müssen, wobei nach diesem Verfahren
- das Substrat aus elektrisch isolierendem Werkstoff (1) vorher auf der Fläche, die die Metallelemente zu tragen hat, eine metallisch leitende Schicht (2 oder 3) aufgetragen wird,
- die Metallelemente (10, 15), die denen der Elemente entsprechen, auf die der Metallüberzug aufzutragen ist und die durch die Metallschicht (2 oder 3) miteinander elektrisch verbunden sind, einer Metallisierungsbehandlung unterzogen werden, und hierauf
– wird mit der Eliminierung der Teile (23) der Metallschicht (2 oder 3) ausserhalb dieser Elemente begonnen, dadurch gekennzeichnet, dass zunächst auf die leitende Metallschicht (2 oder 3) Metallzonen (9, 10, 11 und 15) abgesetzt werden, die sowohl mit den nicht mit einem Metallüberzug zu versehenden Metallelementen als auch mit den damit zu versehenden Metallelementen in Entsprechung stehen, und
– dass nach der Schaffung des Überzugs (19, 20) aus einem nichtoxidierbarem Metall auf den entsprechenden Elementen (10, 15) die Metallzonen mit einem belichteten und entwickelten lichtempfindlichen Film (21, 22) überzogen werden und mit der Eliminierung der äusseren Teile (23) der Metallschicht (2, 3) begonnen wird.

2. Nach dem Verfahren nach Anspruch 1 hergestellte gedruckte Schaltung bestehend aus einem Substrat (1) aus einem elektrisch isolierenden Werkstoff, das auf zumindest einer seiner Flächen Metallelemente trägt, von denen bestimmte mit einem Metallüberzug versehen sind, wobei eine Metallschicht (2, 3) zwischen dem Substrat und den Metallelementen liegt, dadurch gekennzeichnet, dass die mit einer nichtoxidierbaren Metallschicht überzogenen Metallelemente (10, 15) Kontakte zum elektrischen Anschliessen der gedruckten Schaltung mit anderen elektrischen Vorrichtungen bilden.

3. Gedruckte Schaltung nach Anspruch 2, dadurch gekennzeichnet, dass die Kontakte hervorstehend ausgebildet sind.

4. Gedruckte Schaltung nach einem der vorhergehenden Ansprüche 2 oder 3, dadurch gekennzeichnet, dass die Kontakte derart angeordnet sind, dass sie auf die Kontakte einer anderen gedruckten Schaltung wie unter Anspruch 2 oder 3 beschrieben angelegt werden können, wobei der elektrische Anschluss zwischen den beiden gedruckten Schaltungen durch das Zusammenwirken der Kontakte von beiden mit den Kontakten der jeweiligen anderen gewährleistet wird.

**Claims**

1.- Method for making a printed circuit consisting of a substrate (1) of electrically insulating material having, on at least one of its faces, metal elements some of which are to be covered with a metal coating, method wherein:
– said substrate (1) of electrically insulating material is first coated with a conductive metal layer (2 or 3) on said face intended to carry said metal elements;
– said metal elements (10, 15) which correspond to those of said elements which are to be covered with said metal coating and which are electrically connected together by said metal layer (2 or 3), are subjected to an electrodeposition treatment; and
– the portions (23) of said metal layer (2 or 3) external to said elements are then removed, characterized in that;
– metal zones (9, 10, 11 and 15) which are in correspondance with those metal elements which are not to be covered with the metal coating as well as with those which are to be covered are deposited on said conductive metal layer (2 or 3) and
– after making said coating (19, 20) in unoxidizable metal on the corresponding elements (10, 15), said metal zones are covered with a photosensitive film (21, 22) exposed and developed and said external portions (23) of said metal layer (2, 3) are removed.

2. Printed circuit obtained by carrying out the method according to claim 1, consisting of a substrate (1) of electrically insulating material having, on at least one of its faces, metal elements some of which are covered by a metal coating, a metal layer (2, 3) being disposed between said substrate and said metal elements, characterized in that said metal elements (10, 15) coated with an unoxidizable metal layer form contacts, for the electric connection of said printed circuit with other electric devices.

3. Printed circuit according to claim 2, characterized in that said contacts are protuberant.

4. Printed circuit according to one of claims 2 or 3, characterized in that its contacts are so arranged that they can be applied on the contacts of another printed circuit as specified in claims 2 or 3, the electric connection between both printed circuits being ensured by the cooperation of the contacts of the one with the contacts of the other and vice versa.

Fig.1

Fig.2

Fig.3

Fig.4

Fig.5

Fig.6

*Fig: 7*

*Fig: 8*

*Fig: 9*

*Fig: 10*

*Fig: 11*

*Fig: 14*

Fig:12

Fig:13